(19) Europäisches Patentamt
European Patent Office
Office européen des brevets

(11) EP 4 707 824 A1

(12) **EUROPEAN PATENT APPLICATION**

(43) Date of publication:
11.03.2026 Bulletin 2026/11

(21) Application number: 24315411.9

(22) Date of filing: 06.09.2024

(51) International Patent Classification (IPC):
$G01R\ 27/02^{(2006.01)}$     $G01R\ 27/06^{(2006.01)}$

(52) Cooperative Patent Classification (CPC):
G01R 27/06; G01R 27/02

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(71) Applicants:
• Université d'Aix Marseille
13007 Marseille (FR)
• Centre National de la Recherche Scientifique
75016 Paris (FR)

• Ecole Centrale de Marseille
13013 Marseille (FR)

(72) Inventors:
• Ben Soltane, Isam
13013 Marseille (FR)
• Bonod, Nicolas
83320 Carqueiranne (FR)

(74) Representative: Roman, Alexis
SPE Roman-André
35, rue Paradis
B.P. 30064
13484 Marseille Cedex 20 (FR)

(54) **A METHOD FOR DETERMINING ELECTROMAGNETIC OR ACOUSTIC OR ELECTRONIC IMPEDANCE**

(57)    Method for determining electromagnetic, electronic or acoustic impedance of a medium comprising the following steps:
- step 1: measuring reflectance ($R(\omega)$) or transmittance of said medium in order to obtain measured reflectance data ($R_{mes}$) or measured transmittance data at at least two distinct incident angles and at least ten distinct frequencies,
- step 2: calculating electromagnetic, electronic or acoustic impedance ($Z(\omega)$) via an analytical expression in the complex frequency plane.

Fig. 3a          Fig. 3b

**Figure 3**

EP 4 707 824 A1

**Description**

The present invention relates to a method for determining electromagnetic or acoustic impedance of a medium. Determining the impedance is very instructive as it allows for example to study acoustic and electromagnetic properties of new innovative materials. It allows as well to study natural media such as biological media. Regarding electromagnetic impedance, it is to be understood that it is an optical impedance when evaluated in the visible range. Impedance Z(w) is a quantity that characterises the interaction of a structure or medium with a wave signal (acoustic or electromagnetic wave) having a frequency $\omega$ (omega).

Impedance is defined in electromagnetism by the following expression:

$$Z(\omega) = \sqrt{\frac{\mu(\omega)}{\varepsilon(\omega)}}$$

wherein $\mu(\omega)$ is the magnetic permeability and $\varepsilon(\omega)$ is the dielectric permittivity.

Most of the materials are non-magnetic and the impedance simplifies as:

$$Z(\omega) = \sqrt{\frac{1}{\varepsilon(\omega)}} = \frac{1}{n(\omega)}$$

wherein $\varepsilon(\omega)$ is the dielectric permittivity and $n(\omega)$ is the refractive index.

Impedance is defined in acoustics by the following expression:

$$Z(\omega) = \frac{p(\omega)}{v(\omega)}$$

wherein $p(\omega)$ is the acoustic pressure and $v(\omega)$ is the acoustic flow velocity.

Impedance is defined in electronics by the following expression:

$$Z(\omega) = \frac{U(\omega)}{I(\omega)}$$

wherein $U(\omega)$ is the voltage and $I(\omega)$ is the current intensity under AC conditions.

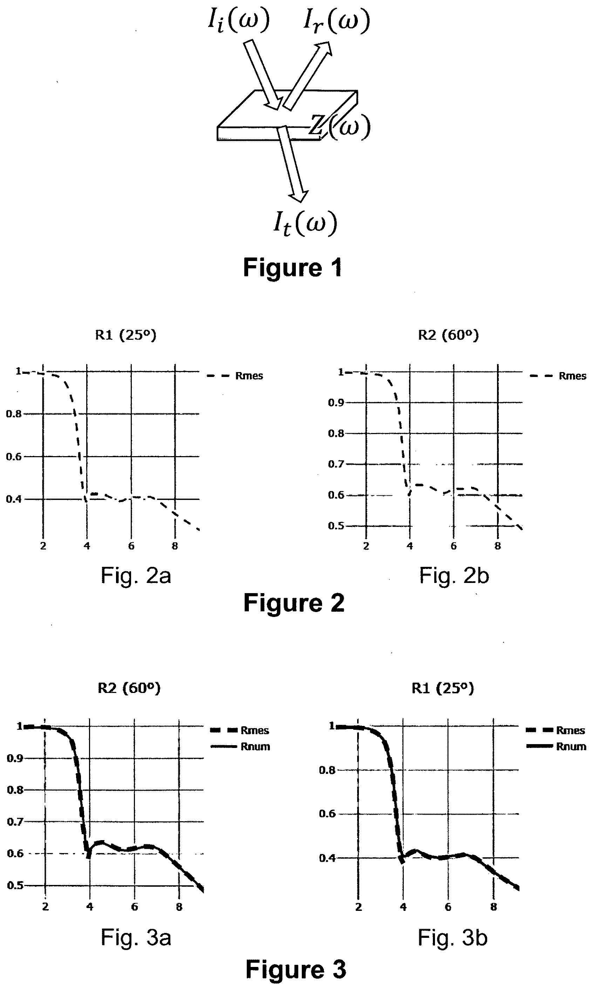

Figure 1 shows schematically the interaction of a medium with a signal having a frequency $\omega$. $I_i$ is the intensity of the incident signal, $I_r$ is the signal reflected by the medium, and $I_t$ is the signal transmitted by the medium.

Impedance is measured indirectly. A acoustic, electronic or electromagnetic signal $I_i$ is sent at a frequency $\omega$. The signal reflected $I_r$ or transmitted $I_t$ by the medium or system is measured.

Two values can be deducted from these measurements, i.e. reflectance and transmittance, that can be calculated from the ratios between the reflected or transmitted signals with the incident signal:

- Reflectance:

$$R(\omega) = \frac{I_r(\omega)}{I_i(\omega)}$$

- Transmittance:

$$T(\omega) = \frac{I_t(\omega)}{I_i(\omega)}$$

The impedance is deducted from these quantities via analytic expressions. For example, in acoustic and electromagnetism, the "Transfer Matrix Method" expresses the link between reflectance or transmittance and impedance:

$$R(\omega) = f(Z(\omega))$$

The expression can be found in electromagnetism in "Ondes électromagnétiques en radioélectricité et en optique," Section VII ,R. Petit, Elsevier Masson, 01/12/1992, or in acoustics in I Herrero-Durá, et al., Matrix formulation in Acoustics: the Transfer Matrix Method. Modelling in Science Education and Learning 2019, 12, ff10.4995/msel.2019.12148ff. ffhal-02366269f.

Using these analytical expressions, reflectance or transmittance has to be measured frequency by frequency, at different incident angles that have to be very carefully controlled, in order to determinate the impedance of a medium.

In this known method, the impedance is obtained by tuning its values in the analytical expression in order to fit the values of the measured reflectance or transmittance. This fitting procedure stops when the difference between the reflectance or transmittance measurement with their values obtained through the analytical expression reaches a minimum error. This approach necessitates a large set of experimental data by measuring the reflectance or transmittance at different angles. Also, the validity of this approach depends on the accuracy of the measurements, in particular on the angles of incidence that have to be controlled with a high accuracy.

The present invention aims to provide a simpler and more accurate method for determining impedance functions from measured transmittance/reflectance values.

In order to achieve this goal, the present invention proposes a method for determining electromagnetic, electronic or acoustic impedance of a medium comprising the following steps:

- step 1: measuring reflectance or transmittance of said medium in order to obtain measured reflectance data at at least two distinct incident angles and at least ten distinct frequencies,
- step 2: calculating electromagnetic, electronic, or acoustic impedance via an analytical expression in the complex frequency plane.

Using an analytical expression function of the complex frequency provides an expression of the impedance in the whole complex frequency plane. Therefore, the impedance Z(w) for any frequency between the set of

real frequencies at which measurements have been carried out is known with great precision. Moreover, this method allows to calculate the impedance slightly outside the edge of the spectral range considered in the study, with good reliability. Importantly, two angles of measurement can be enough to identify the parameters of the analytical expression in the complex frequency plane.

This method can be applied to characterize the impedance of any material or medium under the linear regime.

A "medium" refers to any type of material or device, in any state (solid, liquid, gaseous), in particular a natural medium such as for example a biological medium, or else a synthetic material.

The reflectance is the ratio of the electromagnetic or acoustic power reflected by a medium to that incident on it.

The transmittance is the ratio of the electromagnetic or acoustic power transmitted by a medium to that incident on it.

According to a further preferred aspect, the analytical expression in the complex frequency plane is: wherein:

$$Z(\omega) = Z_{NR} + \sum_{\ell=1}^{N} \left[ \frac{r_\ell}{\omega - \omega_\ell} - \frac{\overline{r_\ell}}{\omega + \overline{\omega_\ell}} \right]$$

$\omega_\ell$ is a pole of the impedance,
N is the number of poles $\omega_\ell$ considered in the sum,
$Z_{NR}$ is a constant,
$r_\ell$ is the residue of the impedance function for the complex frequency $\omega_\ell$.

This analytical expression allows to benefit from all advantages associated with the use of an analytical expression in the complex frequency plane for determining the impedance.

The poles of the impedance are complex frequencies $\omega_\ell$, distinct from the real frequencies $\omega_1, \omega_2, ...$ at which the data are acquired.

N is the number of poles $\omega_\ell$ that has been chosen and used in the analytical expression. $Z_{NR}$ is a constant, a known parameter of the expression. $r_\ell$ is a residue of impedance at the pole $\omega_\ell$. This parameter can be modified.

According to one possible embodiment, step 2 comprises the following sub-steps:

- sub-step 1: choosing parameters $Z_{NR}$, $r_\ell$, $\omega_\ell$, with $\ell$ included between 1 and N,
- sub-step 2: using said chosen parameters, calculating impedance at at least ten distinct frequencies, using said analytical expression in the complex frequency plane,
- sub-step 3: using calculated impedance, applying an analytical expression expressing a link between reflectance or transmittance and impedance, at said two distinct incident angles and said at least five distinct frequencies, in order to obtain calculated reflectances or calculated transmittances,
- sub-step 4: comparing calculated reflectances with measured reflectance data or calculated transmittances with measured transmittance data,
- if there is a difference between said calculated data and said measured data, then in sub-step 5, parameters $Z_{NR}$, $r_\ell$ and $\omega_\ell$ are changed, so as to minimize the difference, and sub-step 2, sub-step 3, sub-step 4 and sub-step 5 are repeated, until the difference between measured data and calculated data falls down a minimum error,
- if the difference between measured and calculated data falls down a minimum error in sub-step 6, the parameters $Z_{NR}$, $r_\ell$, $\omega_\ell$ with $\ell$ included between 1 and N are used to calculate final impedance function.

Preferably, the analytical expression expressing a link between reflectance or transmittance and impedance is the Transfer Matrix Method.

According to another possible embodiment, in sub-step 5, the difference is minimized using a machine-learning library, preferably a machine-learning library named "PyTorch" programmed in Python. PyTorch is known from PyTorch 2: Faster Machine Learning Through Dynamic Python Bytecode Transformation and Graph Compilation | Proceedings of the 29th ACM International Conference on Architectural Support for Programming Languages and Operating Systems, Volume 2, 2024. Using

PyTorch allows to write complex error functions, thanks to automatic differentiation of PyTorch.

In some cases, in sub-step 3, said analytical expression expressing a link between reflectance or transmittance and impedance is according to the thin film model, also known as "thin film stack model". Such an expression is easily and quickly calculable.

According to one embodiment, the method is for determining electromagnetic impedance.

According to one particular case of this embodiment, the method is for determining optical impedance.

According to another possible embodiment, the method is for determining acoustic impedance.

According to another possible embodiment, the method is for determining electronic impedance.

In some cases, in step 1, reflectance or transmittance is measured at only two distinct incident angles.

According to one embodiment, the at least two distinct incident angles include:

- one incident angle comprised between 15° and 25°, preferably about 25°, and
- one incident angle comprised between 50° and 70°, preferably about 60°.

According to one embodiment, in step 1, reflectance is measured.

According to one embodiment, said medium is a natural medium such as a biological medium.

According to another possible embodiment, said medium is a solid material.

BRIEF DESCRIPTION OF THE DRAWINGS

Other advantages and features will become apparent upon reading the description of the following figures, among which:

- Figure 1 schematically shows the interaction of a medium with a signal having a frequency $\omega$. $I_i$ is the intensity of the incident signal, $I_r$ is the signal reflected by the medium, and $I_t$ is the signal transmitted by the medium.
- Figure 2 shows curves of measured reflectance at two distinct incident angles, i.e. 25° as shown on figure 2a, and 60° as shown on figure 2b, expressed as a function of the frequency, for a medium constituted here by gold as a material.
- Figure 3 shows the curves of measured reflectance and calculated reflectance that overlaps, at two distinct incident angles, i.e. 25° as shown on figure 3b, and 60° as shown on figure 3a, expressed as a function of the frequency.

DETAILED DESCRIPTION

In one embodiment, optical impedance of a medium constituted by gold as a material has been determined as follows.

In a first step, the reflectance of said material has been measured in order to obtain measured reflectance data $R_{mes}$ at two distinct incident angles and at 70 distinct frequencies, from near infra-red to UV, such that a curve of the measured reflectance expressed as a function of the frequency is obtained, as exposed hereafter. For this purpose, experimental data of impedance $Z_{mes}$ for gold were collected from an on-line database named Refractive Index Database. In this embodiment, data were used in the thin film model in order to simulate measured reflectance data at two distinct incident angles. The inventors added random variations via the thin film model.

Figure 2 shows measured reflectance $R_{mes}$ curves obtained via the thin film model at two distinct incident angles, i.e. 25° as shown on figure 2a, and 60° as shown on figure 2b, expressed as a function of the frequency. R1 is $R_{mes}$ measured at 25° and R2 is $R_{mes}$ measured at 60°.

In a second step, optical impedance $Z_{num}$ of gold has been calculated via an analytical expression in the complex frequency plane.

In this embodiment, the following analytical expression of impedance $Z(\omega)$ in the complex frequency plane was used:

$$Z(\omega) = Z_{NR} + \sum_{\ell=1}^{N} \left[ \frac{r_\ell}{\omega - \omega_\ell} - \frac{\overline{r_\ell}}{\omega + \overline{\omega_\ell}} \right]$$

This analytical expression is a meromorphic function.

In sub-step 1, parameters $Z_{NR}$, $r_\ell$, $\omega_\ell$ have been chosen, with $\ell$ included between 1 and N. In this embodiment, the parameters have been randomly initialized.

In sub-step 2, using the chosen parameters, impedance $Z_{num}$ has been calculated at 70 distinct frequencies, using the analytical expression.

In sub-step 3, on the basis of $Z_{num}$, $R_{num}$ has been calculated using the thin film model applied to the impedance, at two distinct incidence angles, i.e. 25° and 60°, and at said 70 distinct frequencies:

$$R(\omega) = f(Z(\omega))$$

In sub-step 4, $R_{num}$ and $R_{mes}$ have been compared.

As there was a difference between $R_{num}$ and $R_{mes}$, then in sub-step 5, parameters $Z_{NR}$, $r_\ell$ and $\omega_\ell$ have been changed, in order to minimize the difference, and the second, third, fourth and fifth sub-steps have been repeated, until the difference between measured and calculated data have fallen down a minimum error.

In the embodiment, the difference has been minimized using the machine-learning library PyTorch programmed in Python.

Figure 3 shows the curves $R_{mes}$ and $R_{num}$ that overlap, when $R_{num} = R_{mes}$, at two distinct incident angles, i.e. 25° as shown on figure 3b, and 60° as shown on figure 3a, expressed as a function of the frequency.

When $R_{num} = R_{mes}$, i.e. the difference between measured and calculated data falls down a minimum error, then in sub-step 6, the impedance of the medium has been calculated by using the analytical expression in the complex frequency plane in which parameters $Z_{NR}$, $r_\ell$, $\omega_\ell$ are those for which $R_{num} = R_{mes}$.

In the embodiment, it has been checked that $Z_{mes} = Z_{num}$ by checking that the curves of real and imaginary parts overlap.

Although representative processes have been described in detail herein, those skilled in the art will recognize that various substitutions and modifications may be made without departing from the scope of what is described and defined by the appended claims.

In particular, an embodiment is based on a material, gold, whose reflectance data are already known. In this embodiment, measured reflectance data are obtained from an on-line database, using a model in order to simulate measured reflectance data. In case of a medium for which reflectance and transmittance data are unknown, they will be obtained by measuring it as it is well known from those skilled in the art.

In the embodiment, the reflectance is measured at incident angles of 25° and 60°. Of course, the measurement can be performed at other incident angles.

**Claims**

1. Method for determining electromagnetic, electronic or acoustic impedance of a medium comprising the following steps:

   - step 1: measuring reflectance (R($\omega$)) or transmittance of said medium, in order to obtain measured reflectance data (R$_{mes}$) or measured transmittance data at at least two distinct incident angles and at least ten distinct frequencies,
   - step 2: calculating electromagnetic, electronic or acoustic impedance (Z($\omega$)) via an analytical expression in the complex frequency plane.

2. Method according to claim 1, wherein the analytical expression in the complex frequency plane is:

$$Z(\omega) = Z_{NR} + \sum_{\ell=1}^{N} [\frac{r_\ell}{\omega - \omega_\ell} - \frac{\overline{r_\ell}}{\omega + \overline{\omega_\ell}}]$$

wherein:

   $\omega_\ell$ is a pole of the impedance,
   N is the number of poles $\omega_\ell$ considered in the sum,
   $Z_{NR}$ is a constant,
   $r_\ell$ is the residue of the impedance function for the complex frequency $\omega_\ell$.

3. Method according to claim 2, wherein step 2 comprises the following sub-steps:

   - sub-step 1: choosing parameters $Z_{NR}$, $r_\ell$, $\omega_\ell$, with $\ell$ included between 1 and N,
   - sub-step 2: using said chosen parameters, calculating impedance at at least ten distinct frequencies, using said analytical expression in the complex frequency plane,
   - sub-step 3: using calculated impedance, applying an analytical expression expressing a link between reflectance or transmittance and impedance, at said two distinct incident angles and said at least ten distinct frequencies, in order to obtain calculated reflectances (R$_{num}$) or calculated transmittances,
   - sub-step 4: comparing calculated reflectances (R$_{num}$) with measured reflectance data (R$_{mes}$) or calculated transmittances with measured transmittance data,
   - if there is a difference between said calculated data and said measured data, then in sub-step 5, parameters $Z_{NR}$, $r_\ell$ and $\omega_\ell$ are changed, so as to minimize the difference, and sub-step 2, sub-step 3, sub-step 4 and sub-step 5 are repeated, until the difference between measured and calculated data falls down a minimum error,
   - if the difference between measured and calculated data falls down a minimum error in sub-step 6, the parameters $Z_{NR}$, $r_\ell$, $\omega_\ell$ with $\ell$ included between 1 and N are used to calculate final impedance function.

4. Method according to claim 3, wherein in sub-step 5, the difference is minimized using a machine-learning library, preferably a machine-learning library named "PyTorch", programmed in Python.

5. Method according to claims 3 or 4, wherein in sub-step 3, said analytical expression expressing a link between reflectance or transmittance and impedance is according to the thin film model.

6. Method according to any one of the preceding claims, wherein the method is for determining electromagnetic impedance.

7. Method according to claim 6, wherein the method is for determining optical impedance.

8. Method according to one of claims 1 to 5, wherein the method is for determining acoustic impedance.

9. Method according to one of claims 1 to 5, wherein the method is for determining electronic impedance.

10. Method according to any one of the preceding claims, wherein in step 1, reflectance or transmittance is measured at only two distinct incident angles.

11. Method according to any one of the preceding claims, wherein the at least two distinct incident angles include:

   - one incident angle comprised between 15° and 25°, preferably about 25°, and
   - one incident angle comprised between 50° and 70°, preferably about 60°.

12. Method according to one of the preceding claims, wherein in step 1, reflectance is measured.

13. Method according to one of the preceding claims, wherein said medium is a natural medium such as a biological medium.

14. Method according to one of the preceding claims, wherein said medium is a solid material.

$$I_i(\omega) \quad I_r(\omega)$$

$$Z(\omega)$$

$$I_t(\omega)$$

**Figure 1**

R1 (25°)

R2 (60°)

Fig. 2a

Fig. 2b

**Figure 2**

R2 (60°)

R1 (25°)

Fig. 3a

Fig. 3b

**Figure 3**

Europäisches
Patentamt
European
Patent Office
Office européen
des brevets

# EUROPEAN SEARCH REPORT

**Application Number**

EP 24 31 5411

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 858 794 B (UNIV BEIJING) 19 November 2021 (2021-11-19) | 1,6,10, 12-14 | INV. G01R27/02 |
| A | * figures 2, 3, 5, 6 * | 2-5,7-9 | G01R27/06 |
| X | CN 107 884 625 A (UNIV JIANGSU) 6 April 2018 (2018-04-06) | 1,6, 10-12,14 | |
| A | * figures 1, 3, 4, 5 * | 2-5,7-9, 13 | |
| A | BEN SOLTANE I ET AL: "Multiple-order singularity expansion method", 20231013, vol. 25, no. 10, 13 October 2023 (2023-10-13), XP020481059, DOI: 10.1088/1367-2630/ACFDC4 [retrieved on 2023-10-13] * Eq(1); page 3; figure 4 * | 2 | |

**TECHNICAL FIELDS SEARCHED (IPC)**

G01R

The present search report has been drawn up for all claims

| Place of search | Date of completion of the search | Examiner |
|---|---|---|
| Munich | 29 January 2025 | Agerbaek, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

  .......................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 31 5411

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2025

| Patent document cited in search report | | Publication date | Patent family member(s) | Publication date |
|---|---|---|---|---|
| CN 112858794 | B | 19-11-2021 | NONE | |
| CN 107884625 | A | 06-04-2018 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R. PETIT**. Ondes électromagnétiques en radioélectricité et en optique. Elsevier, 01 December 1992

- **I HERRERO-DURÁ et al.** Matrix formulation in Acoustics: the Transfer Matrix Method. *Modelling in Science Education and Learning*, 2019, 12